# EUROPEAN PATENT APPLICATION

(11) **EP 3 252 487 A1**
(43) Date of publication of application: **06.12.2017**
(21) Application number: 16305638.5
(22) Date of filing: 01.06.2016
(51) Int. Cl.: G01R 31/3185, G01R 31/317

(54) **WAFER-LEVEL PROGRAMMING AND TESTING OF ELECTRONIC DEVICES**

(71) Applicant: NXP USA, Inc., Austin TX 78735 (US)
(72) Inventor: LIU, Lianjun, 5656 AG Eindhoven (NL); LANCE, Philippe Bernard Roland, 5656 AG Eindhoven (NL); SCHLARMANN, Mark Edward, 5656 AG Eindhoven (NL)
(74) Representative: Hardingham, Christopher Mark

(57) **Abstract**

A system includes a plurality of integrated circuit (IC) dies and a test controller on a wafer. The test controller is configured to communicate with one or more of the IC dies. Methodology for testing the IC dies includes receiving and executing a control program at the test controller, wherein execution of the control program enables operation of a test mechanism for determining functionality of the IC dies, and receiving test results at the test controller from the IC dies in response to operation of the test mechanism. The test mechanism may be a built-in self-test mechanism of the IC dies. The test results are indicative of the functionality of the dies. The test results may be recorded in a test results array and the test results array can be communicated from the test controller to an external wafer test unit.

## Description

### TECHNICAL FIELD OF THE INVENTION

The present invention relates generally to integrated circuits. More specifically, the present invention relates to methods and apparatus for testing integrated circuits on a wafer.

### BACKGROUND OF THE INVENTION

Wafer-level probing and/or wafer-level chip scale package (WLCSP) testing of a complimentary metal-oxide-semiconductor (CMOS) wafer containing a plurality of integrated circuit (IC) dies typically requires communication between the external test equipment (e.g., tester) and the device under test (e.g., an IC die). A primary aspect of the communication is to download a test program from the tester to each IC die on the wafer and then receive the test results to verify if the IC die under test is a good die or a bad die.

IC dies are increasingly being fabricated with a build-in self-test (BIST) mechanism or function. A BIST function or mechanism permits an IC die to verify all or a portion of the internal functionality of the IC die. Inclusion of a BIST can reduce reliance upon and/or the complexity of external test equipment, thereby reducing test costs. For example, with the inclusion of the BIST mechanism at each IC die, a test program downloaded from the tester to the IC die may simply initiate execution of the BIST mechanism, receive the test result (e.g., pass/fail) from the BIST, and communicate that result back to the tester.

Thus, with the inclusion of a BIST mechanism, wafer-level testing is becoming faster due to a reduction in communication between the tester and the devices under test. However, wafer-level testing typically entails a process of die-by-die programming and testing in which a probe of the tester must index or step between each of the IC dies on the wafer. The process of indexing or stepping between each of the IC dies on the wafer to perform die-by-die programming and testing is still undesirably time consuming and costly.

### BRIEF DESCRIPTION OF THE DRAWINGS

The accompanying figures in which like reference numerals refer to identical or functionally similar elements throughout the separate views, the figures are not necessarily drawn to scale, and which together with the detailed description below are incorporated in and form part of the specification, serve to further illustrate various embodiments and to explain various principles and advantages all in accordance with the present invention.
FIG. 1 shows a block diagram of a system for testing integrated circuit (IC) dies formed on or in a wafer in accordance with an embodiment;
FIG. 2 shows a simplified top view of the wafer of FIG. 1;
FIG. 3 shows a simplified side view of a probe card of the system and a wafer under test;
FIG. 4 shows an exemplary block diagram of a portion of the wafer showing a wiring interconnection scheme for powering integrated circuit (IC) dies on the wafer;
FIG. 5 shows a flowchart of a wafer-level test process; and
FIG. 6 shows a flowchart of short circuit detection process executed in connection with the wafer-level test process.

### DETAILED DESCRIPTION

In overview, the present disclosure entails methodology and a system for testing integrated circuit (IC) dies formed on a wafer substrate. The system includes one or more test controllers on a wafer substrate that act as a gateway between an external wafer test unit and the devices under test, e.g., IC dies. The test controller may be a microprocessor with embedded memory. The external wafer test unit communicates with the test controller to download a control program and at least a portion of a test results array. Test results from the devices under test may be recorded in the test results array, and the array may thereafter be uploaded via the test controller to, for example, the wafer test unit. Thus, the test controller functions as a miniature tester to communicate with the IC dies on the wafer substrate. By utilizing such an approach, some or all of the IC dies on the wafer can be tested concurrently without the need for communication between the external wafer test unit and each individual IC die. Furthermore, by combining the features of the test controller executing the control program with built-in self-test (BIST) functionality at each of the IC dies, wafer-level testing of the IC dies can be carried out without indexing or stepping the wafer test unit between each of the IC dies on the wafer. Accordingly, test time and test cost can be dramatically reduced.

The instant disclosure is provided to further explain in an enabling fashion the best modes, at the time of the application, of making and using various embodiments in accordance with the present invention. The disclosure is further offered to enhance an understanding and appreciation for the inventive principles and advantages thereof, rather than to limit in any manner the invention. The invention is defined solely by the appended claims including any amendments made during the pendency of this application and all equivalents of those claims as issued. It should be further understood that the use of relational terms, if any, such as first and second, top and bottom, and the like are used solely to distinguish one from another entity or action without necessarily requiring or implying any actual such relationship or order between such entities or actions.

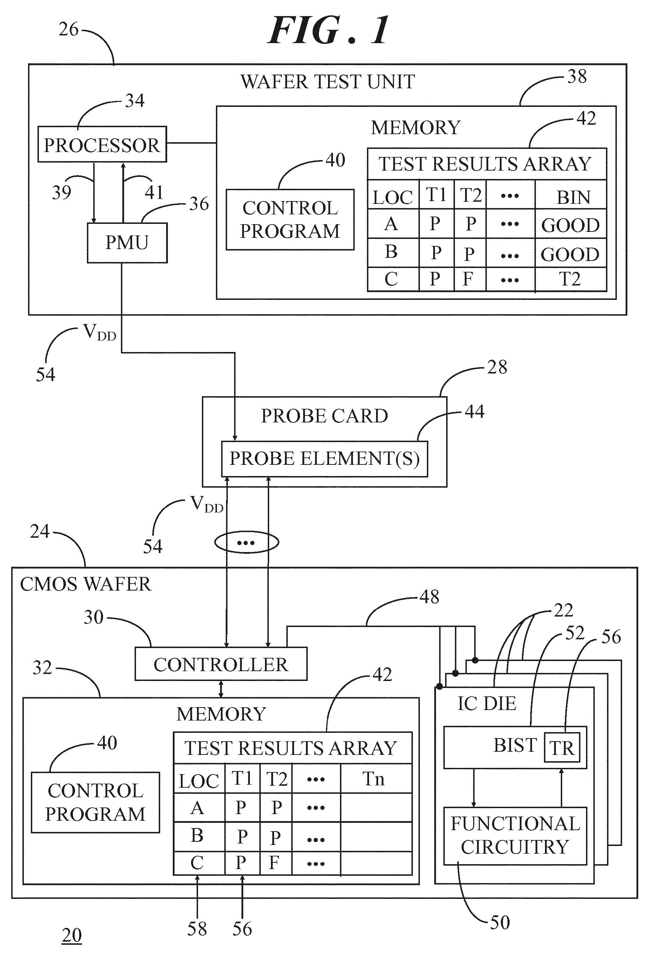

Referring to FIG. 1, FIG. 1 shows a block diagram of a system 20 for testing integrated circuit (IC) dies 22 formed on or in a wafer substrate, referred to herein as wafer 24, in accordance with an embodiment. IC dies 22 may encompass microprocessors, microcontrollers, static random access memory (RAM), and other digital logic circuits fabricated in accordance with complementary metal-oxide-semiconductor (CMOS) process technology. IC dies 22 may further encompass some analog circuits such as CMOS image sensors, data converters, radiofrequency (RF) transceivers, operational amplifiers, and the like. In accordance with CMOS process technology, the IC dies 22 of wafer 24 use a combination of p-type and n-type metal-oxide-semiconductor field-effect-transistors (MOSFETs) to implement logic gates and other digital circuits.

For simplicity of illustration in the block diagram of FIG. 1, wafer 24 is represented by a rectangle and the multiple IC dies 22 are represented by a series of three rectangles that appear to be stacked one on top of the other. It should be readily apparent to those skilled in the art that IC dies 22 are not formed in a stacked relationship on a rectangular wafer 24. Rather, the multiple IC dies 22 of wafer 24 are laterally spaced from one another relative to the plane of the wafer 24.

System 20 generally includes a wafer test unit 26 having a probe card 28, and one or more test controllers 30 (one shown) with an associated memory element 32 formed on wafer 24. Wafer test unit 26 may be a conventional tester, sometimes referred to as a wafer prober, used to test integrated circuits. Wafer test unit 26 can include one or more processors 34, a power management module (PMU) 36, and a memory element 38. In general, processor 34 may control the operation of probe card 28 and power management unit 36. Processor 34 may additionally, or alternatively, enable access to and from memory element 38. Power management unit 36 may be configured by processor 34 via configuration signals 39 to source a current-limited voltage, V_{DD}, 54. Thereafter, processor 34 may monitor the actual voltage and current via readback signals 41. Those skilled in the art will recognize that wafer test unit 26 can include a variety of functional elements and mechanisms for loading and unloading wafers 24 onto a wafer chuck, pattern recognition optics for suitably aligning wafer 24 on the wafer chuck, and so forth. Details of these additional functional elements and mechanisms will not be explained in any greater extent than that considered necessary for the understanding and appreciation of the underlying concepts of the examples set forth herein and in order not to obscure or distract from the teachings herein.

Memory element 38 may have a digital control program 40 and a test results array 42 stored therein. As will be discussed in significantly greater detail below, control program 40 is used by system 20 to initiate testing of IC dies 22 and to upload test results from IC dies 22 back to wafer test unit 26. In some embodiments, the results from each IC die 22 test are stored in test results array 42. In a greatly simplified configuration, test results array 42 may contain a "bin" column which may be used to categorize the tested parts. If all tests associated with a given IC die pass, the bin column can contain "Good." Otherwise, the bin column can be assigned, for example, identification pertaining to the first failing test. The "location" and "bin" columns may be extracted from test results array 42 to create a wafer die map (not shown). The wafer die map can then be sent to subsequent die handling equipment which only picks up the passing IC dies 22 by selecting the bin number of the good IC dies. In other systems, non-passing IC dies 22 may be marked with a small dot of ink in the middle of the die in lieu of test results array 42. When ink dots are used, vision systems on subsequent die handling equipment can disqualify the IC dies 22 by recognizing the ink dot. Test results array 42 represents a simplified format in which certain IC dies 22 at certain locations (LOC) relative to an X-Y plane of a wafer die are either "GOOD" or designated as having failed a particular test, e.g., T2. Those skilled in the art will recognize, however, that a variety of bin designators may be implemented to otherwise further sort IC dies 22.

System 20 is particularly configured to enable testing of IC dies 22 without stepping or indexing between IC dies 22 and without direct communication between IC dies 22 and external wafer test unit 26. Thus, system 20 is configured such that wafer test unit 26 communicates control program 40 to test controller 30, which in turn communicates with IC dies 22. However, test controller 30 and IC dies 22 must be energized prior to communication of control program 40 from wafer test unit 26 to wafer 24. Thus, probe card 28 includes at least one or more probe elements 44. Probe element(s) 44 may be configured for contact with (i.e., touch down on) probe pads (not shown) present on test controller 30.

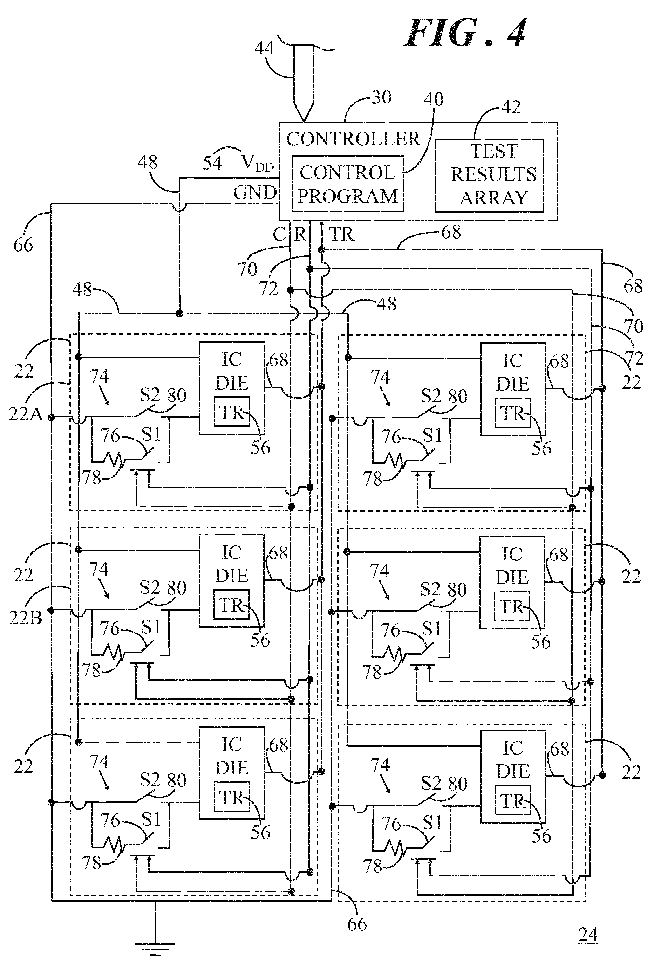

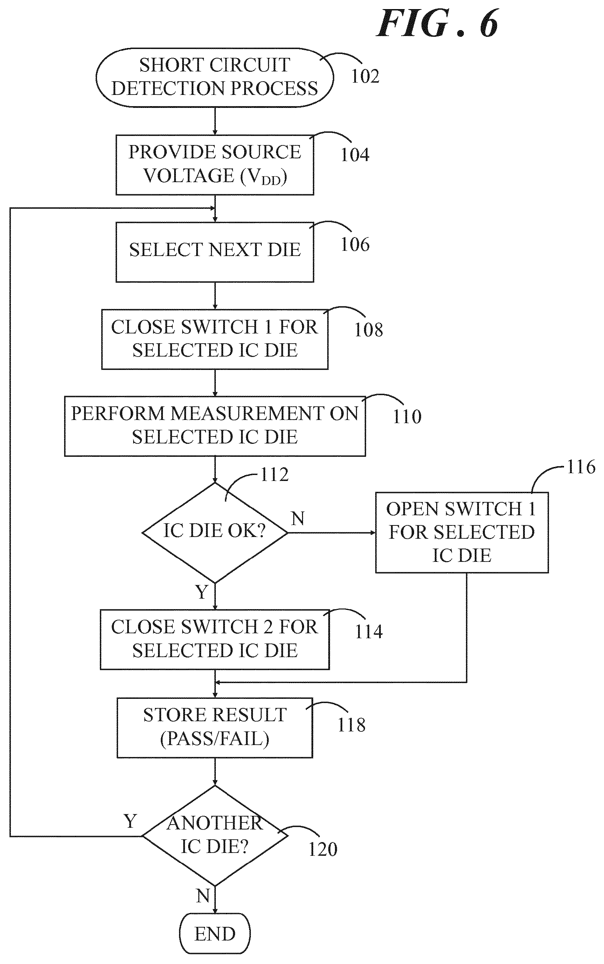

In the illustrated configuration, two lines are interposed between probe elements 44 and test controller 30. Ellipses circumscribed by a dashed line oval overlie the two lines to represent the multiple connections that may be formed between probe elements 44 and test controller 30. These multiple connections may be utilized for powering test controller 30 and IC dies 22, for communicating control program 40 and test results array 42 to test controller 30, and for returning test results in test results array 42 from test controller 30 back to wafer test unit 26 via probe elements 44. As such, source voltage 54, labeled V_{DD}, may be sourced by power management unit 36 to each of IC dies 22 on wafer 24 via probe elements 44, test controller 30, and conductive links 48 in order to energize the circuitry of IC dies 22, as will be discussed in connection with FIGs. 4 and 6.

After test controller 30 is energized, control program 40 and all or a portion of test results array 42 can be downloaded from wafer test unit 26 and stored in memory 32 associated with test controller 30 on wafer 24. Thereafter, IC dies 22 may be tested. Test results array 42 is represented in both memory 38 of wafer test unit 26 and in memory 32 associated with test controller 30 in order to indicate that test results array 42 (or a portion of test results array 42) that includes the locations of IC dies 22 in the X-Y plane of wafer 24 may be downloaded from wafer test unit 26 to test controller 30. During testing of IC dies 22, test results array 42 stored in memory 32 associated with test controller 30 may be populated with test results and thereafter may be uploaded back to wafer test unit 26.

Each of IC dies 22 includes functional circuitry 50. Additionally, each of IC dies 22 may include one or more built-in self-test (BIST) mechanism(s) 52, or BIST processor(s). The one or more BIST mechanism(s) 52 are represented by a single block and will therefore be referred to herein in singular form. BIST mechanism 52 permits each of IC dies 22 to test itself in order to determine the functionality of at least one of its internal functions. By way of example, BIST mechanism 52 functions to verify all or a portion of the internal functionality of its corresponding IC die 22 and produce one or more test results 56 (represented by TR in FIG. 1) of that functionality. Thus, BIST mechanism 52 can be implemented to perform faster and less costly integrated circuit testing.

In a wafer-level testing scenario, test controller 30 functions as a BIST controller and control program 40 includes a set of instructions for initiating execution of BIST mechanism 52, receiving and storing test result(s) 56 in test results array 42 associated with a location 58 within the X-Y plane of wafer 24 of the particular IC die 22 under test, and thereafter communicating test results array 42 back to wafer test unit 26. Accordingly, the function of test controller 30 can be relatively generic for an entire category of IC dies to be tested, especially when the IC dies include the BIST function. As such, this relatively generic test controller 30 can be made available as a separate mask to be inserted on each wafer as a dedicated die.

In some embodiments, test controller 30 may communicate the test results in test results array 42 back to wafer test unit 26 via probe elements 44 as mentioned previously. The test results can therefore be fed back to processor 34 which logs the test results in the appropriate location in test results array 42. In one example, test result(s) 56 may be a simple PASS (represented by "P" in test results array 42) or FAIL (represented by "F" in test results array 42) result. Those skilled in the art will recognize that a number of techniques may be implemented for communicating test results 56 from wafer 24 to wafer test unit 26. Alternatively or additionally, test results array 42 that includes die locations 58 (e.g., columns and rows relative to the X-Y plane of wafer 24) and test results 56, may be communicated to an external processor that is separate from wafer test unit 26.

Accordingly, execution of control program 40 at one or more test controllers 30 on wafer 24 controls operation of BIST mechanism(s) 52 on each IC die 22. Therefore, all IC dies 22 on wafer 24 having at least one stored BIST mechanism 52 can be tested without the need for wafer test unit 26 to program each IC die 22 with control program 40 individually in series, without executing BIST mechanism 52 individually in series, and without requiring physical die-by-die indexing of probe element(s) 44 to receive test result 56. Thus, test time and test costs for an entire wafer 24 may be significantly reduced.

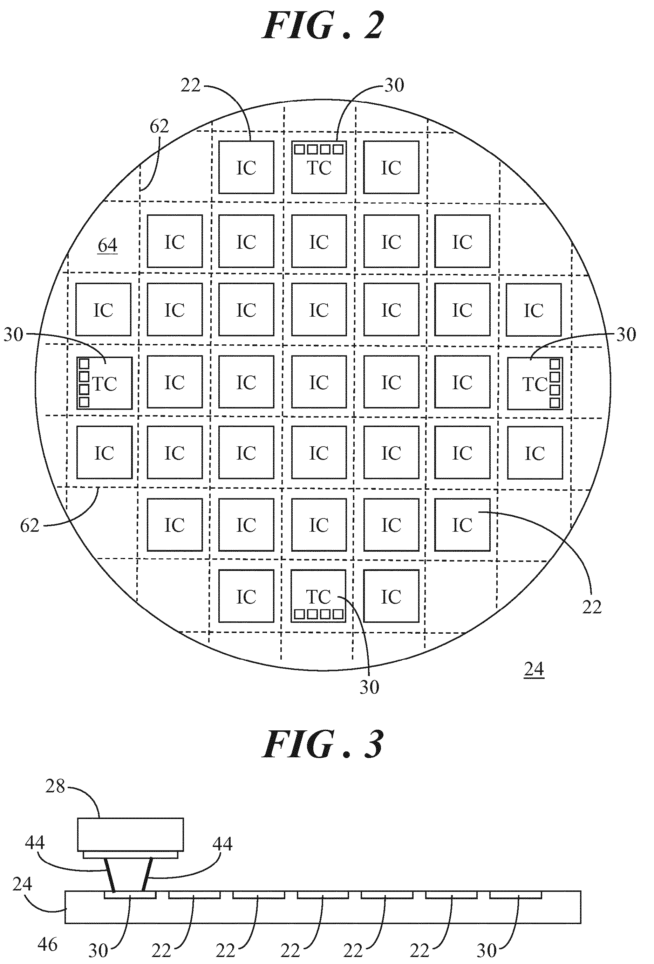

FIG. 2 shows a simplified top view of wafer 24 of FIG. 1 on or in which IC dies 22 (labeled IC) are formed. Additionally, wafer 24 includes one or more test controllers 30 (labeled TC). Boxes formed on test controllers 30 in FIG. 2 represent probe pads that may be utilized for communication with wafer test unit 26 (FIG. 1) via probe elements 44 of probe card 28. Test controllers 30 may be located in an unused portion of wafer 24, such as at an outer periphery of wafer 24. Conductive links 48 (FIG. 1), as well as other unspecified interconnections, are not shown for simplicity. Further, wafer 24 includes only a few IC dies 22 for simplicity of illustration. Those skilled in the art will recognize that a single wafer can include hundreds, thousands, or even tens of thousands of individual IC dies 22.

IC dies 22 are separated by scribe lines 62 (represented by dashed lines) formed in a surface 64 of wafer 24. A first set of scribe lines 62 may extend parallel to one another in one direction, i.e., horizontally across surface 64 of wafer 24. Another set of scribe lines 62 may extend substantially parallel to one another across surface 64 of wafer 24 in a different direction or substantially orthogonal to the first set of scribe lines 62. Scribe lines 62 may form substantially square or rectangular areas, each of which define IC die 22 or semiconductor chip. Scribe lines 62 can be used to separate each of IC dies 22 after fabrication. In an example, each IC die 22 is located within an area circumscribed by scribe lines 62. However, scribe lines 62 may have a predetermined width that permits conductive links 48 (shown in FIG. 1) and other interconnecting traces between test controllers 30 and IC dies 22 to be located within scribe lines 62. Thus, IC dies 22 may be tested at wafer-level, i.e., prior to dicing, during the manufacturing process.

Each test controller 30 is located within an area circumscribed by scribe lines 62. It should be understood, however, that various alternative configurations may be envisioned. For example, each test controller 30 may be located in unused areas at the periphery of wafer 24 so that wafer 24 may be more efficiently used to produce IC dies 22. Four test controllers 30 are shown for simplicity of illustration. In such a configuration, each of the test controllers 30 may be configured to communicate with a distinct subset, or domain, of the IC dies 22 on wafer 24. However, wafer 24 can include more than four or less than four test controllers 30 in accordance with a particular design.

FIG. 3 shows a simplified side view of probe card 28 of system 20 (FIG. 1) and wafer 24 under test. Simplistically, probe card 28 is shown with two probe elements 44. Wafer 24 is shown with a number of IC dies 22 formed therein, where each IC die 22 includes function circuitry 50 (FIG. 1) and BIST mechanism 52 (FIG. 1). Wafer 24 is further shown with two test controllers 30. Probe elements 44 may contact (i.e., touch down on) probe pads 46 formed on wafer 24 for powering test controller 30 and IC dies 22, for communicating control program 40 and test results array 42 to test controller 30, and for returning test results in test results array 42 from test controller 30 back to wafer test unit 26.

FIG. 4 shows a block diagram of a portion of wafer 24 showing an exemplary wiring interconnection scheme for powering and testing IC dies 22 on wafer 24. As mentioned previously, probe element 44 of probe card 28 (FIG. 1) is configured to contact at least one probe pad on test controller 30. In turn, test controller 30 may be interconnected with one or more IC dies 22 via electrically conductive links 48. As such, current controlled source voltage 54, V_{DD}, can be sourced from power management unit 36 (FIG. 1) to test controller 30 and each of IC dies 22 on wafer 24 via probe element 44, test controller 30, and conductive links 48 in order to energize test controller 30 and the circuitry of IC dies 22. Of course, test controller 30 and IC dies 22 may additionally be tied to ground via ground links 66. Furthermore, output links 68 couple an output of each of IC dies 22 with test controller 30 for communicating test result(s) 56 (FIG. 1) from each of IC dies 22 back to test controller 30.

Test controller 30 may be further interconnected with IC dies 22 via switch control links or address lines, referred to herein as a column address line 70 and a row address line 72. Column and row address lines 70, 72 may be interconnected with a switching system 74 for each on the low side, e.g., ground, IC die 22. Each switching system 74 includes a first switch 76, labeled S1, preceded by a resistor 78, and a second switch 80, labeled S2. In general, column and row address lines 70, 72 serve as on/off control for energizing IC dies. Thus, as shown conductive link 48 for source voltage 54, ground link 66, output link 68, column address line 70, and row address line 72 may be, but are not necessarily, shared between IC dies 22. These various connections may be located at unused portions of wafer 24 such as at scribe lines 62 (FIG. 2) since following wafer-level testing and subsequent dicing of wafer 24, they will no longer be used.

In order to perform testing of the IC dies 22, they must first be energized, i.e., turned on. However, due to their interconnection via conductive links 48, an abnormal electrical condition, e.g., short circuit, in any of IC dies 22 should first be detected. As will be discussed in connection with FIG. 6, test controller 30 successively tests each IC die 22 for a short circuit by signaling first switch 76 to close using column and row address lines 70, 72 (while second switch 80 is open) and taking a measurement within the IC die 22 under test. Resistor 78 preceding first switch 76 limits the current to the corresponding IC die 22 in the event that IC die 22 has a defect which shorts source voltage 54 to ground. If the measurement is within an acceptable threshold, test controller 30 determines that no short circuit is detected for the IC die 22 under test. When no short circuit is detected, test controller 30 signals first switch 76 to open via column and row address lines 70, 72. Additionally, test controller 30 signals second switch 80 to close via column and row address lines 70, 72 in order to provide full source power, e.g., current-limited source voltage 54 to IC die 22. Test controller 30 may optionally store the results of the short circuit detection test in test results array 42.

FIG. 4 is highly abstracted. In an example configuration, a flip-flop or another latch circuit having two stable states may be associated with each IC die 22 in order to store state information (e.g., short or no short). Further, a dashed line box encircling each IC die 22 and its associated switching system 74 indicates that this circuitry can be provided as a single component or, alternatively, switching system 74 may be separate from IC die 22.

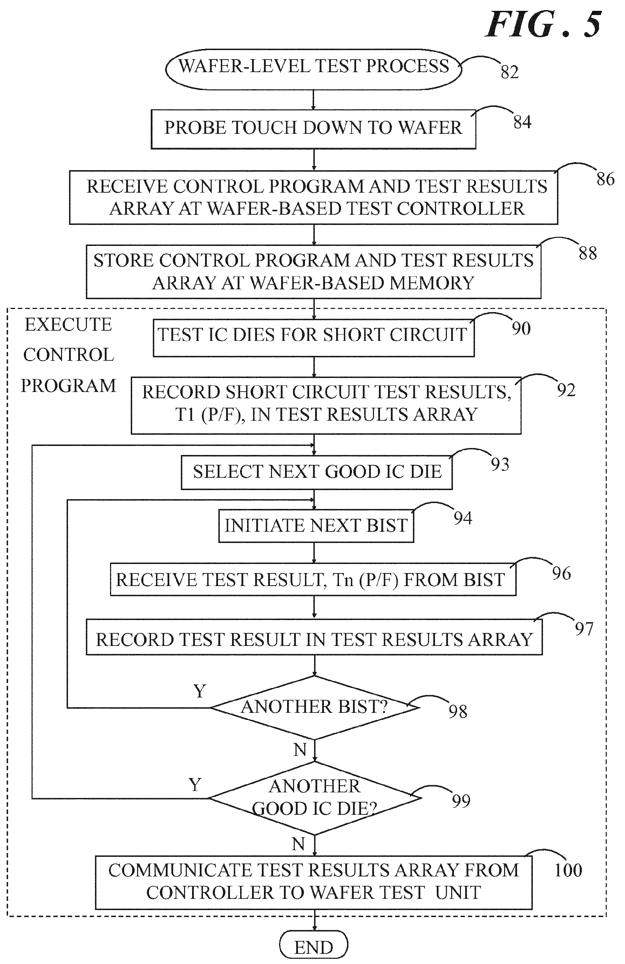

Now referring to FIG. 5 in conjunction with FIG. 1, FIG. 5 shows a flowchart of a wafer-level test process 82 that may be performed utilizing system 20 during, for example, wafer manufacturing. Wafer-level test process 82 provides a generalized description of the operations for downloading control program 40 and test results array 42 to test controller 30, executing control program 40 at test controller 30, and communicating test results 56 back to wafer test unit 26 in order to perform wafer-level testing of IC dies 22 on wafer 24 without indexing or stepping wafer test unit 26 between each of IC dies 22 on wafer 24.

At a block 84 of wafer-level test process 82, touch down of probe elements(s) 44 to one of test controllers 30 of wafer 24 is performed in order to supply current-limited source voltage 54 to wafer 24 and to enable communication between test controller 30 and wafer test unit 26. At a block 86, control program 40 and test results array 42 are downloaded from wafer test unit 26 and received at the wafer-based test controller 30 via probe elements 44. In a configuration in which there is more than one test controller 30 on CMOS wafer 24, each test controller 30 may be associated with a distinct domain or subset of IC dies 22. Thus, only the portion of test results array 42 associated the distinct subset of IC dies 22 may be communicated from wafer test unit 26 to test controller 30. In one embodiment, the communication between wafer test unit 26 and test controller 30 is executed via physical connection with probe elements 44. In alternative embodiments, however, control program 40 and test results array 42 may be downloaded to test controller(s) 30 using wireless magnetic, optical, or radiofrequency transmission techniques.

At a block 88, performed in conjunction with receipt of control program 40 and test results array 42 at block 86, control program 40 and test results array 42 are stored in memory element(s) 32 associated with test controller 30. In some scenarios, the IC dies may not include BIST mechanism 52. Thus, a test mechanism/program may be downloaded to test controller 30 along with control program 40. Thereafter, the downloaded test mechanism/program can be executed in conjunction with control program 40 by test controller 30 to perform testing on IC dies 22.

At some time following download of control program 40 and test results array 42, control program 40 may be executed. The subsequent operational blocks circumscribed by a dashed line box in wafer-level test process pertain to activities that may occur in connection with the execution of control program 40 at test controller 30. Accordingly, at a block 90, IC dies 22 are tested for short circuit of current-limited source voltage 54. Short circuit detection is discussed hereinafter in connection with FIG. 6. In response to block 90, a block 92 is performed to record the results of the short circuit test in test results array 42. In the simplified example shown in FIG. 1, T1 in test results array 42 refers to the test for short circuit. Thus, "P" indicates that a particular IC die 22 is good (i.e., it passed the short circuit test) and "F" indicates that a particular IC die 22 is bad (i.e., it failed the short circuit test).

At a block 93, the next good IC die 22 is selected. In this example, a "good" IC die is one that was determined to not have a short circuit (i.e., that passed the short circuit test). Further, it should be understood that during a first iteration of block 93, the "next" good IC die 22 will be a first IC die 22 to be selected. At a block 94, the continued execution of control program 40 initiates execution of the next test mechanism, which in this example is BIST mechanism 52, for the selected IC die 22. Again, during a first iteration of block 94, the "next" BIST mechanism 52 will be a first BIST mechanism 52 for IC die 22.

At a block 96, test result 56 (e.g., PASS or FAIL) is received at test controller 30 from BIST mechanism 52 for the selected IC die 22. For example, test result 56 may be communicated from IC die 22 to test controller 30 via output line 68 (FIG. 4). At a block 97, test result 56 can be recorded in test results array 42 that is stored in memory 32 on CMOS wafer 24.

It should be recalled that IC dies 22 may include more than one BIST mechanism, in which each BIST mechanism tests verifies a distinct portion of the internal functionality of the IC die. Thus, at a query block 98, a determination is made as to whether another BIST mechanism 52 is associated with the selected IC die 22. When there is another BIST mechanism 52, process control loops back to block 94 to initiate the next BIST mechanism 52 for IC die. However when there is not another BIST mechanism 52 for IC die 22, process control continues with a query task 99 to determine whether there is another good IC die 22 (i.e., one that passed the short circuit test) to be tested. If there is another good IC die 22, process control loops back to block 93 to select the next IC die 22 and perform its associated testing.

Following testing of each of the "good" IC dies 22 in communication with test controller 30 via one or more BIST mechanisms 52 at block 94, receipt of test results 56 at block 96, and recordation of test results 56 at block 97, the now populated test results array 42 (i.e., the test results 56 contained therein) can be communicated from test controller 30 to wafer test unit 26. The communication, or uploading, from test controller 30 to wafer test unit 26 may be performed via the physical contact with probe elements 44. Again, in other embodiments, the communication, or uploading, from test controller 30 to wafer test unit 26 may be performed utilizing dedicated lines or utilizing wireless communication techniques such as magnetic, optical, or radiofrequency techniques. Following block 100, wafer-level testing is complete and wafer-level test process 82 ends. Of course, it should be understood that wafer-level test process 82 may be executed for each test controller 30 on wafer 24 and its associated IC dies 22. As such, although wafer-level test process is described in conjunction with a single test controller 30, the same methodology holds true for each test controller 30.

Referring now to FIGs. 4 and 6, FIG. 6 shows a flowchart of a short circuit detection process 102 executed in connection with wafer-level test process 82 (FIG. 5). More particularly, short circuit detection process 102 is performed by each test controller 30 to successively test their corresponding IC dies 22 on wafer 24 to determine whether any of the IC dies exhibits an abnormal electrical condition and to map the abnormal electrical condition into test results array 42 at block 92 (FIG. 5) of wafer-level test process 82. In this example, the abnormal electrical condition may be a short circuit of source voltage 54 within any of IC dies 22. Prior to execution of short circuit detection process 102, first and second switches 76, 80 of each of switch structures 74 are open. In accordance with short circuit detection process 102, switches 76, 80 are selectively closed in order to test for a short circuit, and thereafter selectively closed to provide current-limited source voltage 54 to only those IC dies 22 that are good, i.e., that do not have a short circuit.

At a block 104 of short circuit detection process 102, source voltage 54 is provided at test controller 30 via probe element 44. At a block 106, the next IC die 22 is selected for short circuit detection. Of course, during a first iteration of block 106, the "next" IC die 22 will be a first IC die 22 in a predetermined test pattern. By way of example, the "next" IC die 22 selected at block 106 is labeled 22A in FIG. 4. In some embodiments, selection may be performed by accessing test results array 42 and suitably signaling the selected IC die 22A via column and row address lines 70, 72.

Next at a block 108, test controller 30 signals the closure of first switch 76 for the selected IC die 22A via, for example, column and row address lines 70, 72 which enables the delivery of a reduced magnitude of source voltage 54 to IC die 22A. Next, at a block 110, a measurement can be made on the selected IC die 22A in accordance with known methodologies to determine whether source voltage 54 is shorted. At a query block 112, a determination is made as to whether the selected IC die is not shorted. That is, the measurement taken in accordance with block 110 falls within some predetermined measurement threshold thereby indicating the IC die 22A is not shorted.

When IC die 22A is not shorted (i.e., IC die 22A is passes the short circuit test), test controller 30 signals the closure of second switch 80 associated with the selected IC die 22A at a block 114. Additionally, test controller 30 can signal the opening of first switch 76. Accordingly, the good IC die 22A is fully energized by a low impedance current-limited voltage source. However, at query block 112 when the measurement taken at block 110 indicates that a short circuit is present in the selected IC die 22A (i.e., IC die 22A fails the short circuit test), test controller 30 signals the opening of first switch 76 at a block 116. Since second switch 80 is also open, no power is provided to the selected IC die 22A and IC die 22A will not be energized.

Following either of blocks 114 or 116, the results of short circuit detection may be stored by test controller 30 in, for example, test results array 42 at a block 118. At a query block 120, test controller 30 determines whether another IC die 22 in the predetermined test pattern of IC dies 22 is to be tested for short circuit. When there is another IC die 22 to be tested, process control loops back to block 106 to select the "next" IC die 22. By way of example, the "next" IC die 22 selected at block 106 is labeled 22B in FIG. 4. However, when there are no further IC dies 22 to be tested, short circuit detection process 102 ends.

Thus, the outcome of short circuit detection process 102 is to fully map those IC dies 22 on wafer 24 that do not have a short circuit with regard to the provision of source voltage 54. Control program 40 executed at test controller 30 can thereafter initiate operation of BIST mechanism(s) 52 (FIG. 1) for each of these "good" IC dies 22 in accordance with the execution of control program 40 of wafer-level test process 82 (FIG. 5). Short circuit detection process 102 provides one technique for distinguishing "good" IC dies 22 from those IC dies 22 that may be defective by having a short circuit malfunction. It should be understood, however, that other methodologies and structures may be envisioned for detecting short circuit malfunctions in IC dies 22 of wafer 24. Additionally, although test controller 30 executing control program 40 is described as performing functions associated with short circuit detection process 102, in alternative embodiments, wafer test unit 26 may instead perform those functions.

It is to be understood that certain ones of the process blocks depicted in FIGs. 5-6 may be performed in parallel with each other or with performing other processes. In addition, it is to be understood that the particular ordering of the process blocks depicted in Figs. 5-6 may be modified, while achieving substantially the same result. Accordingly, such modifications are intended to be included within the scope of the inventive subject matter.

Thus, methodology and a system for testing integrated circuit (IC) dies formed on a wafer substrate have been described. An example embodiment of a method for testing integrated circuit (IC) dies on a wafer substrate comprises receiving a control program at a controller on the wafer substrate, the controller being configured to communicate with one of the IC dies, executing the control program at the controller, wherein the executing comprises enabling operation of a test mechanism for determining a functionality of the one of the IC dies, and receiving a test result from the one of the IC dies in response to the operation of the test mechanism, the test result being indicative of the functionality of the one of the IC dies.

An example embodiment of a system comprises a wafer substrate, a plurality of integrated circuit (IC) dies on the wafer substrate, a controller on the wafer substrate, the controller being configured to communicate with one of the IC dies, and a probe pad on the wafer substrate and electrically coupled with the controller, wherein the probe pad is adapted for contact by a probe element of a wafer test unit, the probe element being configured to output a control program for receipt at the controller via the probe pad.

Another example embodiment of a method for testing integrated circuit (IC) dies on a wafer substrate, each of the IC dies including a built-in self-test (BIST) mechanism for determining a functionality of the each of the IC dies, the method comprising receiving a control program and a test results array at a controller on the wafer substrate, wherein the die map includes a location of each of the IC dies on the wafer substrate, and the controller is configured to communicate with one of the IC dies, and executing the control program at the controller, wherein the executing comprises enabling initiation of an operation of the BIST mechanism at the one of the IC dies. The method further includes receiving a test result from the one of the IC dies in response to the operation of the BIST mechanism, the test result being indicative of a functionality of the one of the IC dies, recording the test result in the die map in association with the location of the one of the IC dies, and communicating the die map with the test result recorded therein from the controller to an external wafer test unit.

Embodiments also relates to a method for testing integrated circuit (IC) dies on a wafer substrate, each of said IC dies including a built-in self-test (BIST) mechanism for determining a functionality of said each of said IC dies, and said method comprising:
receiving a control program and a test results array at a controller on said wafer substrate, wherein said test results array includes a location of each of said IC dies on said wafer substrate, and said controller is configured to communicate with one of said IC dies;
executing said control program at said controller, wherein said executing comprises enabling initiation of an operation of said BIST mechanism at said one of said IC dies;
receiving a test result from said one of said IC dies in response to said operation of said BIST mechanism, said test result being indicative of a functionality of said one of said IC dies;
recording said test result in said test results array in association with said location of said one of said IC dies; and
communicating said test results array with said test result recorded therein from said controller to an external wafer test unit.

Receiving said control program and said test results array comprises outputting said control program and said test results array from said wafer test unit for receipt at said controller.

Executing comprises enabling initiation of said operation of said BIST mechanism at each of a plurality of said IC dies on said wafer substrate;
said receiving said test result comprises receiving a plurality of test results in response to said operation of said BIST mechanism, one each of said test results being from one each of said plurality of said IC dies;
said recording comprises recording said plurality of test results in said test results array in association with corresponding locations of said plurality of IC dies; and
said communicating communicates said test results array with said plurality of test results recorded therein.

A switch structure is interposed between said controller and said one of said IC dies, and said method further comprises:
activating said switch structure, in response to said execution of said control program, to enable at least a portion of source power to be provided to said one of said IC dies;
determining whether said one of said IC dies exhibits an abnormal electrical condition in response to provision of said at least a portion of said source power;
when said one of said IC dies does not exhibit said abnormal electrical condition, providing full source power to said IC die via said switch structure and enabling said initiation of said operation of said BIST mechanism at said one of said IC dies; and
when said one of said IC dies exhibits said abnormal electrical condition, discontinuing provision of said source power to said one of said IC dies and abstaining from enabling said initiation of said operation of said BIST mechanism at said one of said IC dies.

The methodology and system, discussed above, and the inventive principles thereof utilize one or more test controllers on a wafer substrate that act as a gateway between an external wafer test unit and the devices under test. The external wafer test unit communicates with the test controller to download a control program and a wafer die map. Test results from the devices under test can be uploaded via the test controller to, for example, the wafer test unit. Thus, the test controller functions as a miniature tester to communicate with the IC dies on the wafer substrate. By utilizing such an approach, all of the IC dies on the wafer can be programmed concurrently without the need for communication between the external wafer test unit and each individual IC die. Furthermore, by combining the features of the test controller executing the control program with built-in self-test (BIST) functionality at each of the IC dies, wafer-level testing/probing of the IC dies can be carried out without indexing or stepping the wafer test unit between each of the IC dies on the wafer. Accordingly, test time and test cost can be dramatically reduced.

This disclosure is intended to explain how to fashion and use various embodiments in accordance with the invention rather than to limit the true, intended, and fair scope and spirit thereof. The foregoing description is not intended to be exhaustive or to limit the invention to the precise form disclosed. Modifications or variations are possible in light of the above teachings. The embodiment(s) was chosen and described to provide the best illustration of the principles of the invention and its practical application, and to enable one of ordinary skill in the art to utilize the invention in various embodiments and with various modifications as are suited to the particular use contemplated. All such modifications and variations are within the scope of the invention as determined by the appended claims, as may be amended during the pendency of this application for patent, and all equivalents thereof, when interpreted in accordance with the breadth to which they are fairly, legally, and equitably entitled.

## Claims

1. A method for testing integrated circuit (IC) dies on a wafer substrate comprising:
receiving a control program at a controller on said wafer substrate, said controller being configured to communicate with one of said IC dies;
executing said control program at said controller, wherein said executing comprises enabling operation of a test mechanism for determining a functionality of said one of said IC dies; and
receiving a test result from said one of said IC dies in response to said operation of said test mechanism, said test result being indicative of said functionality of said one of said IC dies.

2. The method of claim 1 wherein said receiving said control program comprises outputting said control program from an external wafer test unit for receipt at said controller and further comprising storing said control program in a memory element associated with said controller.

3. The method of claims 1 or 2 further comprising:
receiving a test results array at said controller;
storing said test results array in a memory element associated with said controller; and
recording said test result in said test results array in association with a location of said one of said IC dies on said wafer substrate.

4. The method of claim 3 wherein:
said receiving said test result comprises receiving a plurality of test results, one each of said test results being from one each of a plurality of said IC dies on said wafer substrate; and
said recording comprises recording said plurality of test results in said test results array in association with corresponding locations of said plurality of IC dies.

5. The method of any preceding claim wherein:
said test mechanism is a built-in self-test (BIST) mechanism formed within each of said IC dies;
said executing comprises enabling initiation of said BIST mechanism by said one of said IC dies; and
said receiving said test result comprises receiving said test result from said BIST mechanism in response to operation of said BIST mechanism.

6. The method of any preceding claim further comprising communicating said test result from said controller to an external wafer test unit.

7. The method of claim 1 wherein a switch structure is interposed between said controller and said one of said IC dies, and said method further comprises:
activating said switch structure, in response to said execution of said control program, to enable at least a portion of source power to be provided to said one of said IC dies;
determining whether said one of said IC dies exhibits an abnormal electrical condition in response to provision of said at least a portion of said source power;
when said one of said IC dies does not exhibit said abnormal electrical condition, providing full source power to said IC die via said switch structure and enabling said operation of said test mechanism; and
when said one of said IC dies exhibits said abnormal electrical condition, discontinuing provision of said source power to said one of said IC dies and abstaining from enabling said operation of said test mechanism.

8. A system comprising:
a wafer substrate;
a plurality of integrated circuit (IC) dies on said wafer substrate;
a controller on said wafer substrate, said controller being configured to communicate with one of said IC dies, and said controller being further configured to communicate with an external wafer test unit to receive a control program output from said wafer test unit.

9. The system of claim 8 further comprising a memory element on said wafer substrate and associated with said controller, said memory element being adapted to store said control program.

10. The system of claim 9 wherein said wafer test unit is further configured to output a test results array of a location of each of said IC dies on said wafer substrate, and said memory element is adapted to store said test results array.

11. The system of claims 8 to 10 wherein said controller is one of a plurality of controllers on said wafer substrate, and one each of said controllers is configured to communicate with a distinct subset of a plurality of said IC dies on said wafer substrate.

12. The system of claims 8 to 11 wherein said controller is further configured to execute said control program and receive a test result from said one of said IC dies, said test result being indicative of a functionality of said one of said IC dies.

13. The system of claims 8 to 12 wherein said one of said IC dies includes a built-in self-test (BIST) mechanism to determine said functionality of said one of said IC dies, and said controller is configured to communicate with said BIST mechanism, wherein execution of said control program enables initiation of an operation of said BIST mechanism and receipt of said test result from said BIST mechanism.

14. The system of claims 8 to 13 further comprising a switch structure interposed between said controller and said one of said IC dies, wherein execution of said control program initiates activation of said switch structure to enable at least a portion of source power to be provided to said one of said IC dies.

15. The system of claim 14 wherein said at least a portion of said source power is provided to said one of said IC dies to determine whether said one of said IC dies exhibits an abnormal electrical condition, and said execution of said control program enables activation of said switch structure to enable full source power to be provided to said IC die via said switch structure when a determination is made that said one of said IC dies does not exhibit said abnormal electrical condition.
